Europäisches Patentamt

European Patent Office

Office européen des brevets

(19)

(11) **EP 1 233 443 A1**

(12) **EUROPEAN PATENT APPLICATION**
published in accordance with Art. 158(3) EPC

(43) Date of publication:
21.08.2002 Bulletin 2002/34

(51) Int Cl.7: **H01L 21/027**, G03F 1/16,
H01J 37/305

(21) Application number: 01961350.4

(22) Date of filing: 04.09.2001

(86) International application number:
**PCT/JP01/07649**

(87) International publication number:
**WO 02/021582 (14.03.2002 Gazette 2002/11)**

(84) Designated Contracting States:
**AT BE CH CY DE DK ES FI FR GB GR IE IT LI LU MC NL PT SE TR**

(30) Priority: **05.09.2000 US 230559 P**

(71) Applicant: **Hoya Corporation**
**Shinjuku-ku, Tokyo 161-0032 (JP)**

(72) Inventor: **AMEMIYA, Isao, Hoya Corporation**
**Tokyo 161-0032 (JP)**

(74) Representative: **Read, Matthew Charles et al**
**Venner Shipley & Co.**
**20 Little Britain**
**London EC1A 7DH (GB)**

(54) **TRANSFER MASK, METHOD OF DIVIDING PATTERN OF TRANSFER MASK, AND METHOD OF MANUFACTURING TRANSFER MASK**

(57)    In a pattern of a transfer mask to transfer a transfer pattern to a substrate to be transferred by the use of energy beams, the transfer mask being made by forming an aperture pattern in a thin film portion supported by a supporting frame portion, when the transfer pattern includes a shielding pattern in which one part is connected to at least the periphery of the transfer mask, a shielding pattern portion, where the ratio of the surface area of the pattern surface portion on the transfer mask to a sectional area of a supporting portion is larger than 5000, is split and developed.

1) Leaf    2) Corner    3) Tan    4) Cross
two-point support

Fig. 1

**Description**

<u>Technical Field</u>

The present invention relates to a stencil type transfer mask having an aperture pattern to transfer a pattern onto a substrate to be transferred using an electron-beam projection exposure method, and a pattern transfer method using the transfer mask.

<u>Background Art</u>

In lithography technologies to form an interconnection pattern or the like, in association with trends towards extreme fine pattern designing, it is difficult to form a pattern using an optical lithography technology as a conventional general-purpose technology. To realize finer pattern designing, exposure technologies using charged-particle beams such as electron beams or ion beams, and short-wavelength beams from an X-ray source are being examined positively. Among them, in an electron-beam delineation technology, an initial point-beam delineation and a variable-shape delineation method for changing the size or shape of a rectangular beam to delineating a pattern have been proposed, and subsequently, a cell projection delineation method for delineating a part of a pattern partially together through a mask and repeating such a processing has been proposed from the viewpoint of an improvement of the pattern accuracy and a reduction in delineation time, and the technology has been developed. Subsequent to the cell projection delineation method, S. D. Berger et al. proposed a new electron-beam projection system (SCALPEL system) about eight years ago. After that, a similar delineation system (PREVAIL system) and various proposals regarding a transfer mask (reticle) structure to be applied to those delineation systems and a method for manufacturing the mask have been made.

For example, Japanese Patent No. 2829942 (Japanese Unexamined Patent Application Publication No. 7-201726) relates to the PREVAIL system invented by H. C. Pfeiffer et al. In brief, a stencil mask, in which an opening (aperture) pattern with a predetermined size is formed in a predetermined arrangement in each small field, is prepared. Charged-particle beams are irradiated to the small fields. The opening pattern is reduced and transferred to an exposed substrate, on which a photosensitive material is formed, using the beams shaped by the opening pattern through an optical system. The predetermined patterns split and formed on the mask are connected to each other on the exposed substrate to form a device pattern. As a transfer mask proposed for such a system, a stencil type mask in which a pattern portion comprises an opening that is not shielded completely is used as a main structure (Japanese Unexamined Patent Application Publication No. 10-261584, Japanese Unexamined Patent Application Publication No. 10-260523, or the like). For the stencil type mask, the backside surface of a pattern field is split and reinforced by a strut (bridge) structure, thereby improving a reduction in distortion of the pattern field. Consequently, pattern position accuracy is improved.

As a mask structure for the SCALPEL system, a scattering mask (reticle) is proposed other than the stencil mask. Those are specifically described in, for example, a cited document (by S. D. Berger & J. M. Gibson, APPL. PHYS. LETTERS 57 (2) (1990) 153), Japanese Unexamined Patent Application Publication No. 10-261584, and Japanese Unexamined Patent Application Publication No. 10-321495. In the above descriptions, for the mask structure, a heavy-metal film is formed on a membrane (self-supporting thin film) made of SiN or the like and a desired pattern is formed into the heavy-metal film. According to a method using the mask structure, electron beams are irradiated to both the films. The electron scattering degrees of the films differs depending on the presence or absence of an electron-beam scatterer. Exploiting the difference of the scattering degrees, beam contrast on a wafer is obtained, thereby reducing and transferring the pattern.

According to those exposure systems, high-resolution properties serving as features of the charged-particle beams are satisfied and a pattern finer than 0.1 μm can be formed. Compared with the cell projection method, due to sharp enlargement of a shot size (for example, the maximum shot size on the exposed substrate is increased from 5 μm to 250 μm), throughput in production of a device is improved (for example, in case of an 8-inch substrate having the minimum line width of 0.08 μm, throughput of 30 wafers/hour or higher). The system has ability capable of manufacturing a general-purpose device. The system is of much practical use.

As mentioned above, in the electron-beam projection exposure (EPL: PREVAIL, SCALPEL), two kinds of mask structures, namely, the stencil type and the membrane type are proposed. The stencil mask is fabricated using an SOI wafer by shaping processing such as dry etching. Since mask magnification is set to low magnification, for example, 4 times, the mask pattern is extremely fined. For the thickness, 2 μm is standard from the viewpoint of workability and heat conductivity. The stencil type conventionally has a problem regarding the drop of a ring pattern called a doughnut problem. As measures, a complementary mask method for performing pattern split has been proposed. However, in association with finer pattern designing, it is considered that the mechanical intensity is deteriorated depending on a pattern formed in a transfer field. It is considered that the complementation in a wide area is needed.

As related arts regarding the complementation of the pattern, for example, Japanese Unexamined Patent Application Publication No. 11-26372 is mentioned. This publication discloses that a cantilever pattern (low-supporting pattern: pattern in which one end is connected to a mask material) needs the complementation. This publication also discloses that a pattern in which both ends are supported has no problem of intensity.

However, especially in a cantilever (leaf) portion or an L&S (bridge) portion, there is apprehension regarding mask workability due to low mechanical strength and breakage caused by stress concentration. The present inventor has studied a relation between the pattern size and the intensity of the cantilever pattern and a relation with the intensity of the both-end-supported pattern, thereby accomplishing the present invention.

Disclosure of the Invention

According to a first aspect of the present invention as means for solving the above-mentioned subjects, the followings are provided:

(1) A transfer mask to transfer a transfer pattern to a substrate to be transferred by the use of energy beams, the transfer mask being made by forming an aperture pattern in a thin film portion supported by a supporting frame portion, the transfer mask comprising:

a transfer pattern which is a shielding pattern, in which one part is connected to at least the periphery of the transfer mask, and in which a shielding pattern portion, where the ratio of the surface area of a pattern surface portion on the transfer mask to the sectional area of a supporting portion is larger than 5000, is split and developed.

(2) A transfer mask to transfer a transfer pattern to a substrate to be transferred by the use of energy beams, the transfer mask being made by forming an aperture pattern in a thin film portion supported by a supporting frame portion, the transfer mask comprising:

a transfer pattern which is a shielding pattern, in which one part is connected to at least the periphery of the transfer mask, and which is formed so that a shielding pattern portion, where the ratio of the surface area of a pattern surface portion on the transfer mask to the sectional area of a supporting portion is equal to or less than 5000, is not split and developed.

(3) A transfer mask to transfer a transfer pattern to a substrate to be transferred by the use of energy beams, the transfer mask being made by forming an aperture pattern in a thin film portion supported by a supporting frame portion,
wherein the transfer mask is adapted to form a shielding pattern of such a type that shielding pattern portions which are supported and fixed in at least two positions of the periphery of the transfer mask are closely adjacent to each other, and the transfer mask includes a pattern obtained by splitting and developing a pattern in which the length of the shielding pattern on the transfer mask is equal to or larger than an allowable length y of the shielding pattern represented by Equation 2 so that the length is smaller than the allowable length y and the density of the pattern becomes more coarse.

$$\text{allowable pattern length } (y) = 412.5X - 95.33 \qquad \text{Equation (2)}$$

X: pattern width
(4) The transfer mask according to the above (1) or (2), including a plurality of complementary pattern fields.
(5) A pattern split method of a transfer mask to transfer a transfer pattern to a substrate to be transferred by the use of energy beams, the transfer mask being made by forming an aperture pattern in a thin film portion supported by a supporting frame portion,
wherein, when the transfer pattern has a shielding pattern in which one part is supported and fixed to the periphery of the transfer mask, whether it is necessary to split and develop the aperture pattern is determined in accordance with the surface area of the shielding pattern and the sectional area of a supporting portion.
(6) The transfer mask pattern split method according to the above (5), wherein when the ratio of the surface area of a pattern surface portion of the shielding pattern on the transfer mask to the sectional area of the supporting portion is equal to or larger than 5000, the pattern is split and developed to form a plurality of complementary pattern fields, and except this case, the pattern is not split.
(7) A pattern split method of a transfer mask to transfer a transfer pattern to a substrate to be transferred by the use of energy beams, the transfer mask being made by forming an aperture pattern in a thin film portion supported by a supporting frame portion,

wherein when the transfer pattern has a shielding pattern of such a type that shielding pattern portions which are supported and fixed in at least two positions of the periphery of the transfer mask are closely adjacent to each other, whether it is necessary to split and develop the aperture pattern is determined in accordance with the length of the shielding pattern and the pattern width.

(8) The transfer mask pattern split method according to claim (7), wherein when the length of the shielding pattern on the transfer mask is equal to an allowable length y of the shielding pattern represented by Equation 2, the pattern is split and developed so that the length is smaller than the allowable length y and the density of the pattern becomes more coarse, and when the length is smaller than the allowable length y, the pattern is not split and developed.

$$\text{allowable pattern length (y)} = 412.5X - 95.33$$

X: pattern width

(9) A manufacturing method of a transfer mask to transfer a transfer pattern to a substrate to be transferred by the use of energy beams, the transfer mask being made by forming an aperture pattern in a thin film portion supported by a supporting frame portion, the method comprising:

a step of determining whether it is necessary to split the pattern on pattern data in accordance with a method according to any one of the above (5) to (8), after that, performing a pattern proximity-effect correction processing to the pattern data, converting the data into data for delineation, transferring the data to a photosensitive material on the substrate, and forming the aperture pattern in the thin film portion through a dry etching method.

(10) A manufacturing method of a transfer mask to transfer a transfer pattern to a substrate to be transferred by the use of energy beams, the transfer mask being made by forming an aperture pattern in a thin film portion supported by a supporting frame portion, the method comprising:

a step of performing a pattern proximity-effect correction processing to pattern data, after that, determining whether it is necessary to split the pattern on the pattern data in accordance with a method according to any one of the above (5) to (8), subsequently performing the pattern proximity-effect correction processing and a conversion processing into data for delineation, transferring the data to a photosensitive material on the substrate, and forming the aperture pattern in the thin film portion through a dry etching method.

(11) A transfer mask which is manufactured by a method according to the above (10) or (11).

(12) A pattern transfer method for transferring a pattern using a transfer mask according to any one of the above (1) to (4) and (11).

Brief Description of the Drawings

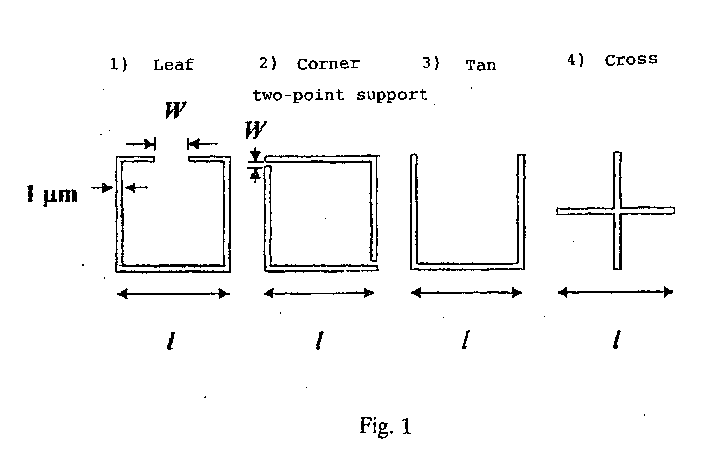

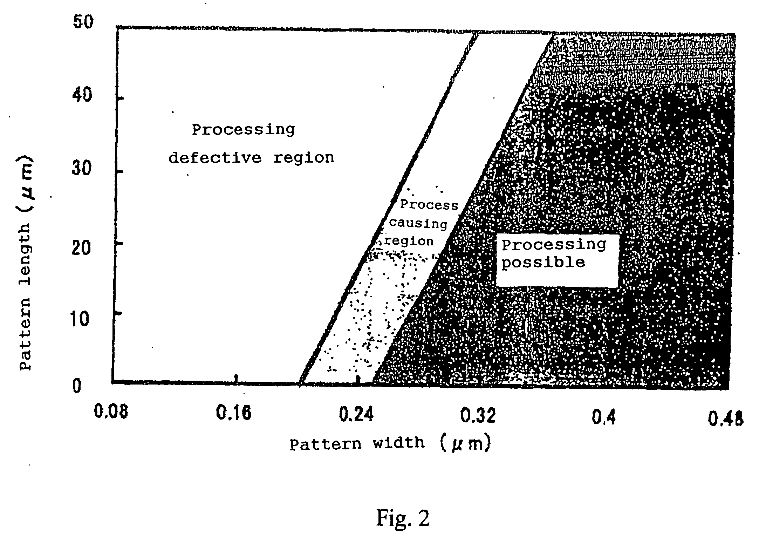

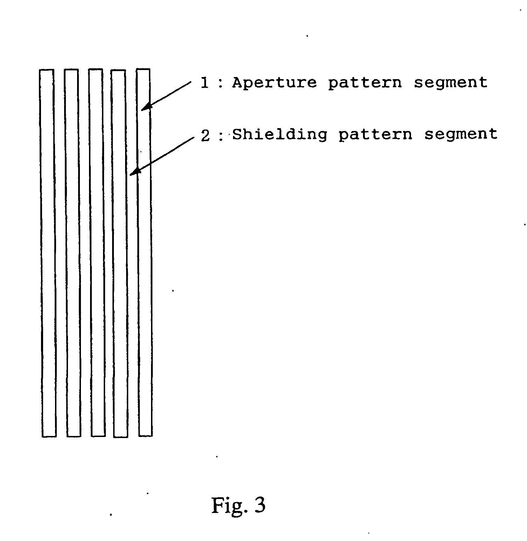

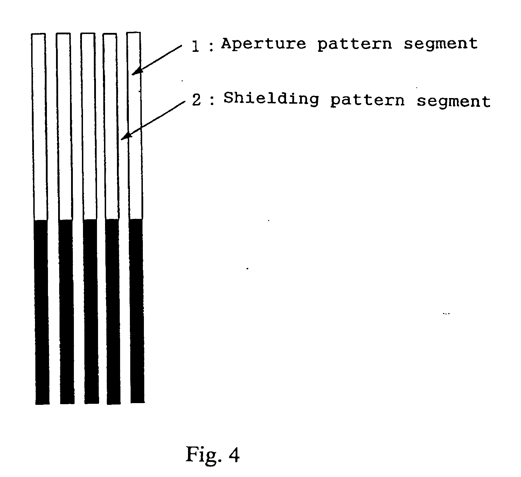

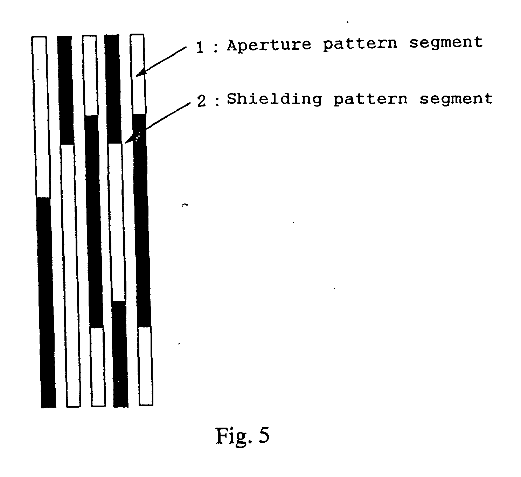

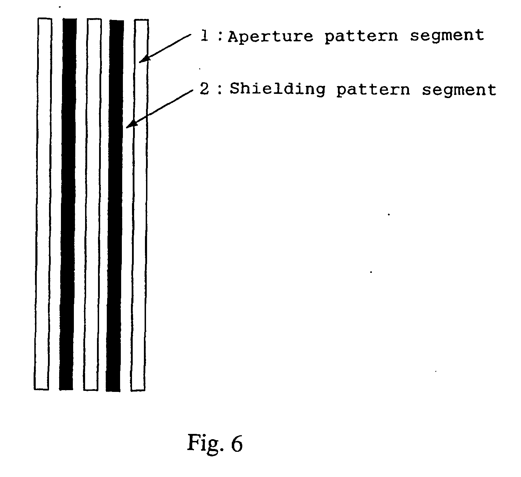

Fig. 1 is a schematic diagram of a low-supporting pattern in an embodiment 1; Fig. 2 is a graph showing a relation between a pattern length and a pattern width regarding the split of a linear pattern in an embodiment 2; Fig. 3 is a pattern schematic diagram (base data) of the embodiment 2; Fig. 4 is a pattern schematic diagram showing a pattern split example (undesirable example) in the embodiment 2; Fig. 5 is a pattern schematic diagram showing a pattern split example (preferred example) in the embodiment 2; and Fig. 6 is a pattern schematic diagram showing a pattern split example (preferred example) in the embodiment 2.

Best Mode for Carrying Out the Invention

(Embodiment 1)

In the present embodiment, a case where a transfer pattern has a shielding pattern in which one part is connected to the periphery of the transfer pattern will now be explained.

First, an aperture pattern on a stencil mask to form a transfer pattern having a shielding pattern supported at a position of the periphery was evaluated.

As evaluated patterns, patterns formed so that L&Ss have various modified sizes and aspects (aspect ratios) and low-supporting portions have modified sizes were used. A mask was formed using an SOI substrate (Silicon On Insulator: substrate having such a structure that two silicon substrates are adhered through $SiO_2$) and the external view thereof was observed with a light microscope or the like to make evaluation. It is considered as a result that in association with trends towards finer pattern designing, the rigidity in the lateral direction of the pattern is deteriorated, the influence of surface tension of pure water or the like is exerted upon self-supporting. Since the $SiO_2$ film was eliminated using dilute hydrofluoric acid or BHF, it was confirmed that the surface of silicon was active. It is considered that the above was caused due to local stress concentration. Formation defective caused by such a deterioration in mechanical intensity requires the complementation.

Fig. 1 shows examples of the low-supporting patterns. Regarding those patterns, the intensities of the patterns having various modified sizes were confirmed as shown in Table 1.

Table 1

| I | W |
|---|---|
| 10 μm | 1, 2, 5 |
| 100 μm | 1, 5, 50 |
| 500 μm | 1, 50, 250 |

Consequently, in the large pattern (for example, when the thickness is 2 μm, the area is equal to or larger than 0.04 $mm^2$), when a supporting area is equal to or smaller than 1/4 of the outer circumference of the low-supporting pattern, it was found that the pattern was easily broken due to stress concentration at the end of an aperture portion during processing irrespective of the supporting shape and supporting size. In the small pattern (for example, when the thickness is 2 μm, the area is equal to or smaller than 0.01 $mm^2$), it turned out that the low-supporting pattern such as a cantilever pattern was not broken and the complementation was not needed. In other words, it was found that the area effect was large in the low-supporting pattern, the complementation was necessary in the large pattern, and the complementation was not needed in the small pattern. Consequently, even in case of the low-supporting pattern, it is unnecessary to forcibly realize the complementation, resulting in a reduction in pattern area. When the split of the small low-supporting pattern is avoided, it is possible to avoid the volume of pattern data from extremely increasing.

That is, consequently, as to the splitting (complementation) of the pattern, in case of the low-supporting pattern (cantilever pattern), when the ratio of the surface area of one plane of a pattern supported by the supporting portion to the sectional area of the supporting portion is larger than 5000, the pattern split is performed. In this case, the pattern area is split so that the maximum ratio of the pattern surface area to the sectional area of the supporting portion is equal to or less than 5000.

Subsequently, on the basis of the above evaluation result, for the transfer pattern in which the ratio of the surface area on the mask to the sectional area of the supporting portion is larger than 5000, the complementary split is performed on the stencil mask.

A split method is performed so that each pattern area density in an exposed area is substantially uniformed and a micro pattern is not formed by the pattern split. Two mask fields are formed. When the transfer pattern is equal to or less than 0.01 $mm^2$ on the mask (the ratio of the surface area of the pattern to the sectional area of the supporting portion is equal to or less than 5000), the complementation is not performed and one pattern field is formed in the same way as that of the above evaluation.

That is, the stencil mask is manufactured by, for example, the following method.

A pattern data processing is performed as follows. After the so-called outline processing is performed to pattern data, whether the pattern split is needed is determined according to the above method. According to the determination result, the pattern split is performed to the pattern data requiring the pattern split. After that, the so-called proximity-effect correction processing is performed to the pattern data, and the data is then converted into EB (electron-beam delineation) data.

As for manufacturing the mask, a thin film ($SiO_2$ or the like) for an etching mask layer is first formed on an SOI substrate and resist is formed in mask blanks in each of which the rear surface is subjected to a recess processing. The EB data is delineated onto the resist and is then developed to form a resist pattern. After that, an etching mask layer is formed, dry etching is then performed to form an aperture pattern (scattering layer pattern), and the etching mask layer is removed. After that, washing and inspection are performed to complete the transfer mask.

When the transfer pattern is formed using the mask by a device such as an EB stepper, a fine transfer pattern of 100 nm or less for a high-technology device can be formed.

The transfer pattern having a shielding pattern in which one part is connected to the periphery thereof is not limited to the above-mentioned patterns. The above reference can be applied to a low-supporting pattern with a complicated shape.

(Embodiment 2)

According to the present embodiment, a case where a transfer pattern has a shielding pattern in which both ends are connected to the transfer pattern will now be described.

First, an aperture pattern on a stencil mask to form such a shielding pattern, in which both ends are connected to the transfer pattern, was evaluated.

Next, the intensities of linear patterns having various sizes as shown in Table 2 were confirmed.

Table 2

| Width (μm) | Length (μm) |
|---|---|
| 0.24 | 10 |
| 0.32 | 20 |
| 0.40 | 30 |
| 0.48 | 40 |

The evaluation was performed after a wet cleaning processing. An estimate of the amount of pattern distortion in the evaluation can be represented by Equation 1.

$$\delta = (1/384) \cdot (Wl^3 / EI) \qquad \text{Equation (1)}$$

Where,

$\delta$:     the amount of pattern distortion
E:     Young's modulus
I:     second moment of area
W:     uniformly distributed load
1 :     pattern length

Flexural rigidity EI can be obtained using the following equations.
Second moment of area in the longitudinal direction:

$$I_v = ab^3/12$$

Second moment of area in the lateral direction:

$$I_h = a^3 b/12$$

Where, reference symbol a denotes a pattern width and reference symbol b denotes a pattern length.

The pattern intensity generally cited in the stencil mask is concerned with the vertical direction. As for an EPL stencil mask, since the thickness is equal to 2 μm, the intensity in the vertical direction presents no problem. When the mask is actually processed, the intensity in the vertical direction presents no problem so long as the ratio of the pattern width to the length is about 2000, as described in Japanese Unexamined Patent Application No. 11-26372. However, in order to form a pattern according to an NGC (next-generation lithography) spec, the minimum width of an aperture (stencil) pattern formed in the EPL stencil mask is set to about 0.2 to 0.3 μm, so that the flexural rigidity (EI) in the lateral direction is remarkably deteriorated. Consequently, it is found that the pattern intensity is also deteriorated. It turns out that the pattern is deformed due to the surface tension of a solvent such as pure rinse during processing and the adjacent patterns are adhered and fixed to each other in a dense pattern portion due to an intermolucular force. From this problem, it turns out that the pattern complementation is needed in the both-end-supported pattern, which presents no problem so far. Fig. 2 shows the pattern length allowed in case of 1:1 L&S with respect to the split of the linear (straight line, L-shaped, cross, or the like) pattern. The pattern deformation by gravitation within an elastic region can be obtained using Equation 1.

In the equation shown in this instance, the length of a pattern, which can be normally processed when a pure water processing used for a mask manufacturing step is performed, the surface tension effect of pure water is considered, and the mask manufacture processing is performed, is obtained by experiments.

The equation used in the calculation is primarily approximated with respect to the most important pattern size range of 0.2 μm to 0.5 μm. In the future, when trends toward finer pattern designing are advanced and the pattern size on the mask is finer than 0.2 μm, the equation is not limited to the above equation.

$$\text{Allowable pattern length (y)} = 412.5X - 95.33 \qquad \text{Equation (2)}$$

X: pattern width

For example, the maximum allowable pattern length of a 1:1 L&S pattern having a size of 0.2 μm is equal to 3.67 μm from the above equation. That is, when a pattern has a length longer than the above, the pattern split is performed.

In this case, even in case of a pattern having, for example, a size of 0.2 μm and a thickness of 2 μ, as long as the duty ratio is 1:2 L&S, the allowable pattern length is equal to 69.7 μm. As mentioned above, it becomes clear that the presence or absence of the pattern split depends on the pattern duty ratio and the thickness. Consequently, since the number of patterns to be split can be limited, the extreme increase of the amount of pattern data can be suppressed.

Next, on the basis of the above evaluation result, the stencil mask is subjected to a complementation processing so that the shielding pattern length for transfer satisfies Equation 2. For example, a 1:1 L&S pattern having aperture pattern segments 1 and shielding pattern segments 2 as shown in Fig. 3 is split. In this case, as shown in Fig. 4, when the pattern is simply split according to the ratio of the pattern length to the pattern width (aspect ratio), the split segments are two-dimensionally split at predetermined positions. In this case, the split causes stress concentration and becomes a factor of membrane damage. It is not desirable. Accordingly, the pattern split at a predetermined length is avoided as much as possible. For example, when the 1:1 L&S pattern is split as shown in Fig. 5, the deviation of the coarse density of the pattern can be prevented and the stress concentration of the pattern can also be prevented. When the split is performed so that the duty ratio is se to 1:3 as shown in Fig. 6, the coarse density can be reduced. It is preferable. In this instance, in Figs. 4 to 6, the portions filled with black are portions subjected to the complementation processing.

As for a pattern in which two mask fields are formed and the length of the transfer shielding pattern is equal to or less than the allowable pattern length obtained by Equation 2, the complementation is not performed and one pattern field is formed in the same way as that of the foregoing evaluation. The specific stencil mask manufacturing method is the same as that of the embodiment 1. When a transfer pattern is formed using those masks, a fine pattern of 100 nm or less can be transferred and formed.

According to the present invention, the constitution and the manufacturing method of the stencil mask are not limited to those in the above embodiments.

Industrial Applicability

The present invention can be utilized to obtain a transfer mask used for an electron-beam projection exposure method. Particularly, since whether complementation is needed is determined to form an aperture pattern, it is possible to obtain a transfer mask, in which the pattern area can be reduced, an extreme increase in pattern data can be suppressed, and a transfer pattern can be transferred with high precision.

**Claims**

1. A transfer mask to transfer a transfer pattern to a substrate to be transferred by the use of energy beams, the transfer mask being made by forming an aperture pattern in a thin film portion supported by a supporting frame portion, said transfer mask comprising:

   a transfer pattern which is a shielding pattern, in which one part is connected to at least the periphery of the transfer mask, and in which a shielding pattern portion, where the ratio of the surface area of a pattern surface portion on the transfer mask to the sectional area of a supporting portion is larger than 5000, is split and developed.

2. A transfer mask to transfer a transfer pattern to a substrate to be transferred by the use of energy beams, the transfer mask being made by forming an aperture pattern in a thin film portion supported by a supporting frame portion, said transfer mask comprising:

a transfer pattern which is a shielding pattern, in which one part is connected to at least the periphery of the transfer mask, and which is formed so that a shielding pattern portion, where the ratio of the surface area of a pattern surface portion on the transfer mask to the sectional area of a supporting portion is equal to or less than 5000, is not split and developed.

3. A transfer mask to transfer a transfer pattern to a substrate to be transferred by the use of energy beams, the transfer mask being made by forming an aperture pattern in a thin film portion supported by a supporting frame portion,

wherein said transfer mask is adapted to form a shielding pattern of such a type that shielding pattern portions which are supported and fixed in at least two positions of the periphery of the transfer mask are closely adjacent to each other, and said transfer mask includes a pattern obtained by splitting and developing a pattern in which the length of the shielding pattern on the transfer mask is equal to or larger than an allowable length y of the shielding pattern represented by Equation 2 so that the length is smaller than the allowable length y and the density of the pattern becomes more coarse.

$$\text{allowable pattern length (y)} = 412.5X - 95.33 \qquad \text{Equation (2)}$$

X: pattern width

4. The transfer mask according to claim 1 or 2, including a plurality of complementary pattern fields.

5. A pattern split method of a transfer mask to transfer a transfer pattern to a substrate to be transferred by the use of energy beams, the transfer mask being made by forming an aperture pattern in a thin film portion supported by a supporting frame portion,

wherein, when the transfer pattern has a shielding pattern in which one part is supported and fixed to the periphery of the transfer mask, whether it is necessary to split and develop the aperture pattern is determined in accordance with the surface area of the shielding pattern and the sectional area of a supporting portion.

6. The transfer mask pattern split method according to claim 5, wherein when the ratio of the surface area of a pattern surface portion of the shielding pattern on the transfer mask to the sectional area of the supporting portion is equal to or larger than 5000, the pattern is split and developed to form a plurality of complementary pattern fields, and except this case, the pattern is not split.

7. A pattern split method of a transfer mask to transfer a transfer pattern to a substrate to be transferred by the use of energy beams, the transfer mask being made by forming an aperture pattern in a thin film portion supported by a supporting frame portion,

wherein when the transfer pattern has a shielding pattern of such a type that shielding pattern portions which are supported and fixed in at least two positions of the periphery of the transfer mask are closely adjacent to each other, whether it is necessary to split and develop the aperture pattern is determined in accordance with the length of the shielding pattern and the pattern width.

8. The transfer mask pattern split method according to claim 7, wherein when the length of the shielding pattern on the transfer mask is equal to an allowable length y of the shielding pattern represented by Equation 2, the pattern is split and developed so that the length is smaller than the allowable length y and the density of the pattern becomes more coarse, and when the length is smaller than the allowable length y, the pattern is not split and developed.

$$\text{allowable pattern length (y)} = 412.5X - 95.33$$

X: pattern width

9. A manufacturing method of a transfer mask to transfer a transfer pattern to a substrate to be transferred by the use of energy beams, the transfer mask being made by forming an aperture pattern in a thin film portion supported by a supporting frame portion, said method comprising:

a step of determining whether it is necessary to split the pattern on pattern data in accordance with a method

**EP 1 233 443 A1**

according to any one of claims 5 to 8, after that, performing a pattern proximity-effect correction processing to the pattern data, converting the data into data for delineation, transferring the data to a photosensitive material on the substrate, and forming the aperture pattern in the thin film portion through a dry etching method.

10. A manufacturing method of a transfer mask to transfer a transfer pattern to a substrate to be transferred by the use of energy beams, the transfer mask being made by forming an aperture pattern in a thin film portion supported by a supporting frame portion, said method comprising:

a step of performing a pattern proximity-effect correction processing to pattern data, after that, determining whether it is necessary to split the pattern on the pattern data in accordance with a method according to any one of claims 5 to 8, subsequently performing the pattern proximity-effect correction processing and a conversion processing into data for delineation, transferring the data to a photosensitive material on the substrate, and forming the aperture pattern in the thin film portion through a dry etching method.

11. A transfer mask which is manufactured by a method according to claim 10 or 11.

12. A pattern transfer method for transferring a pattern using a transfer mask according to any one of claims 1 to 4, and 11.

**9**

1) Leaf    2) Corner    3) Tan    4) Cross

two-point support

$W$

$W$

1 μm

$l$    $l$    $l$    $l$

Fig. 1

Fig. 2

1 : Aperture pattern segment

2 : Shielding pattern segment

Fig. 3

1 : Aperture pattern segment

2 : Shielding pattern segment

Fig. 4

1 : Aperture pattern segment

2 : Shielding pattern segment

Fig. 5

1 : Aperture pattern segment

2 : Shielding pattern segment

Fig. 6

## INTERNATIONAL SEARCH REPORT

| | International application No. |
|---|---|
| | PCT/JP01/07649 |

A. CLASSIFICATION OF SUBJECT MATTER
Int.Cl⁷    H01L21/027    G03F1/16
        H01J37/305

According to International Patent Classification (IPC) or to both national classification and IPC

B. FIELDS SEARCHED

Minimum documentation searched (classification system followed by classification symbols)
Int.Cl⁷    H01L21/027    G03F1/16
        H01J37/305

Documentation searched other than minimum documentation to the extent that such documents are included in the fields searched
Jitsuyo Shinan Koho      1926-1996    Toroku Jitsuyo Shinan Koho  1994-2001
Kokai Jitsuyo Shinan Koho  1971-2001    Jitsuyo Shinan Toroku Koho  1996-2001

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | US 5537487 A (Fujitsu Limited),<br>16 July, 1996 (16.07.96),<br>Claims; Figs. 2, 4, 11<br>& US 5347592 A,    & JP 5-36593 A | 1-12 |
| X | US 5874198 A (Nikon Corporation)<br>23 February, 1999 (23.02.99)<br>Figs. 7, 10<br>& JP 9-129541 A | 1-12 |
| X | JP 7-29793 A (Nikon Corporation)<br>31 January, 1995 (31.01.95)<br>Figs. 2,7,8,10 (Family: none) | 1-12 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26 November, 2001 (26.11.01) | 04 December, 2001 (04.12.01) |

| Name and mailing address of the ISA/ | Authorized officer |
|---|---|
| Japanese Patent Office | |
| Facsimile No. | Telephone No. |

Form PCT/ISA/210 (second sheet) (July 1992)